# EUROPEAN PATENT SPECIFICATION

(11) **EP 4 546 966 B1**
(45) Date of publication and mention of the grant of the patent: **14.10.2026**
(21) Application number: 23852720.4
(22) Date of filing: 20.06.2023
(51) Int. Cl.: G02B 7/00, H05K 7/20, H05K 9/00, G02B 27/01

(54) **ELECTRONIC DEVICE COMPRISING STRUCTURE FOR DISSIPATING HEAT TO OUTSIDE**
ELEKTRONISCHE VORRICHTUNG MIT STRUKTUR ZUR WÄRMEABLEITUNG NACH AUSSEN
DISPOSITIF ÉLECTRONIQUE COMPRENANT UNE STRUCTURE POUR DISSIPER LA CHALEUR VERS L'EXTÉRIEUR

(30) Priority: 12.08.2022 KR 20220101649; 08.09.2022 KR 20220114061
(43) Date of publication of application: 30.04.2025
(73) Proprietor: Samsung Electronics Co., Ltd., Suwon-si, Gyeonggi-do 16677 (KR)
(72) Inventor: KIM, Musul, Suwon-si Gyeonggi-do 16677 (KR); YOON, Jongmin, Suwon-si Gyeonggi-do 16677 (KR); JUNG, Sangchul, Suwon-si Gyeonggi-do 16677 (KR)
(74) Representative: Gulde & Partner
(86) International application number: PCT/KR2023/008531
(87) International publication number: WO 2024/034833

(56) References cited:
- KR-A- 20160 105 228
- KR-A- 20160 105 228
- KR-A- 20220 041 353
- KR-A- 20220 041 353
- US-A1- 2016 212 889
- US-A1- 2017 184 863
- US-A1- 2017 311 483
- US-A1- 2019 107 870
- US-A1- 2021 185 855

## Description

### [Technical Field]

The present disclosure relates to an electronic device including a structure for dissipating heat to the outside.

### [Background Art]

An electronic device may include various electronic components to meet a demand of a user. As the electronic device operates, the electronic components in the electronic device may generate heat. For example, the heat generated from one electronic component may degrade a performance of the electronic device by transferring to another electronic component in the electronic device. For example, the heat generated from one electronic component may cause inconvenience to the user by transferring to the outside of the electronic device. Further prior art is known from US 2021/185855 A1, US 2017/311483 A1 and KR 2022 0041353 A.

### [Disclosure]

### [Technical Solution]

An electronic device according to an embodiment may comprise a housing. The electronic device according to an embodiment may comprise a first bracket, forming a through hole, disposed in the housing. According to an embodiment, the electronic device may comprise a first display, disposed on a surface of the first bracket, configured to be movable with respect to the first bracket. According to an embodiment, the electronic device may comprise a printed circuit board disposed on another surface of the first bracket opposite to the surface of the first bracket. According to an embodiment, the electronic device may comprise a fan disposed between the printed circuit board and the first bracket. According to an embodiment, the electronic device may comprise a heat dissipation member including a first region attached to a surface of the first display facing the surface of the first bracket, and a second attached to the other surface of the first bracket, facing the fan. According to an embodiment, a portion of the heat dissipation member, between the first region and the second region, may pass through the through hole and may be configured to be deformable according to movement of the first display with respect to the first bracket.

An electronic device according to an embodiment may include a housing including a first surface facing a user when the electronic device is worn on the user, and a second surface opposite to the first surface. According to an embodiment, the electronic device may include a first bracket, forming a through hole, disposed in the housing. According to an embodiment, the electronic device may include a moving flange including a portion facing a surface of the first bracket, and another portion disposed outside the housing, and is rotatable with respect to the first bracket. According to an embodiment, the electronic device may include a first display coupled to the portion of the moving flange. According to an embodiment, the electronic device may include a fan disposed in the housing and facing the other surface of the first bracket opposite to the surface of the first bracket. According to an embodiment, the electronic device may include a printed circuit board disposed between the second surface and the fan. According to an embodiment, the electronic device may include a heat dissipation member including a first region attached to a surface of the first display facing the surface of the first bracket, and a second region, attached to the other surface of the first bracket, facing the fan. According to an embodiment, a portion of the heat dissipation member, between the first region and the second region, may pass through the through hole, and may be foldable according to movement of the first display with respect to the first bracket.

### [Description of the Drawings]

FIG. 1 is a block diagram of an electronic device in a network environment according to various embodiments.
FIG. 2A is a perspective view of an exemplary electronic device according to an embodiment.
FIG. 2B is an exploded perspective view of an exemplary electronic device according to an embodiment.
FIG. 2C is a partial cross-sectional view illustrating an example of an exemplary electronic device according to an embodiment, cut along line A-A' of FIG. 2A.
FIG. 3A is a cross-sectional view illustrating an example of an exemplary electronic device according to an embodiment, cut along line B-B' of FIG. 2A.
FIG. 3B is a cross-sectional view illustrating an example of an exemplary electronic device according to an embodiment, cut along line B-B' of FIG. 2A.
FIG. 4 is a rear view of an exemplary electronic device according to an embodiment.
FIG. 5A is a top plan view of a printed circuit board of an exemplary electronic device according to an embodiment.
FIG. 5B is a cross-sectional view illustrating an example of a printed circuit board of an exemplary electronic device according to an embodiment, cut along line C-C' of FIG. 5A.

### [Mode for Invention]

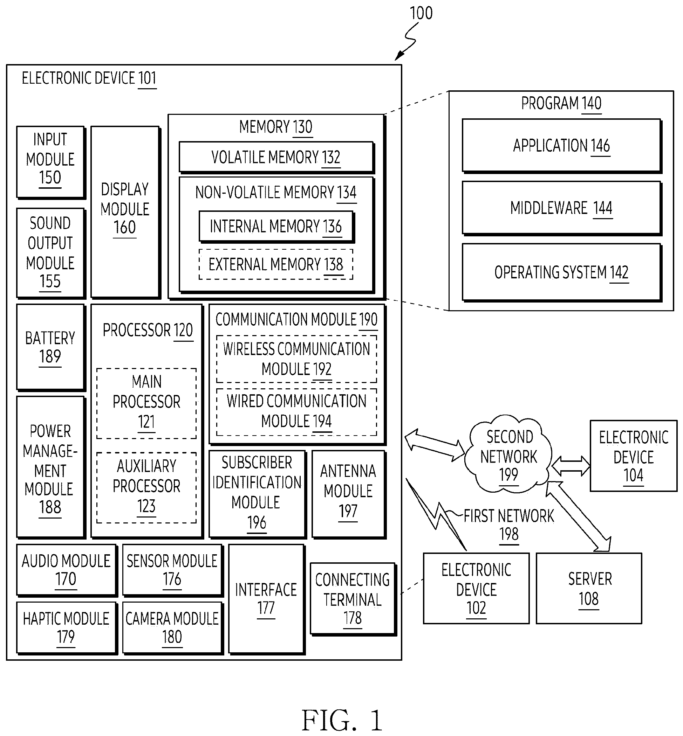

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

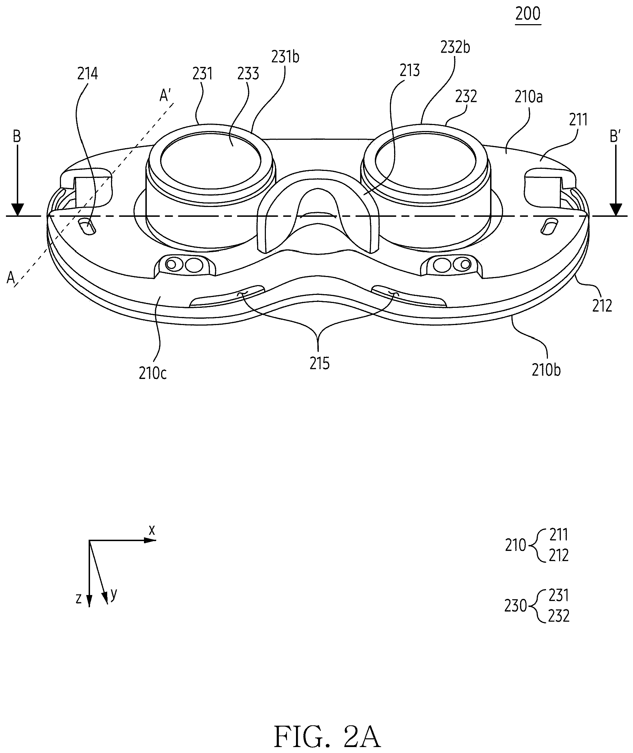

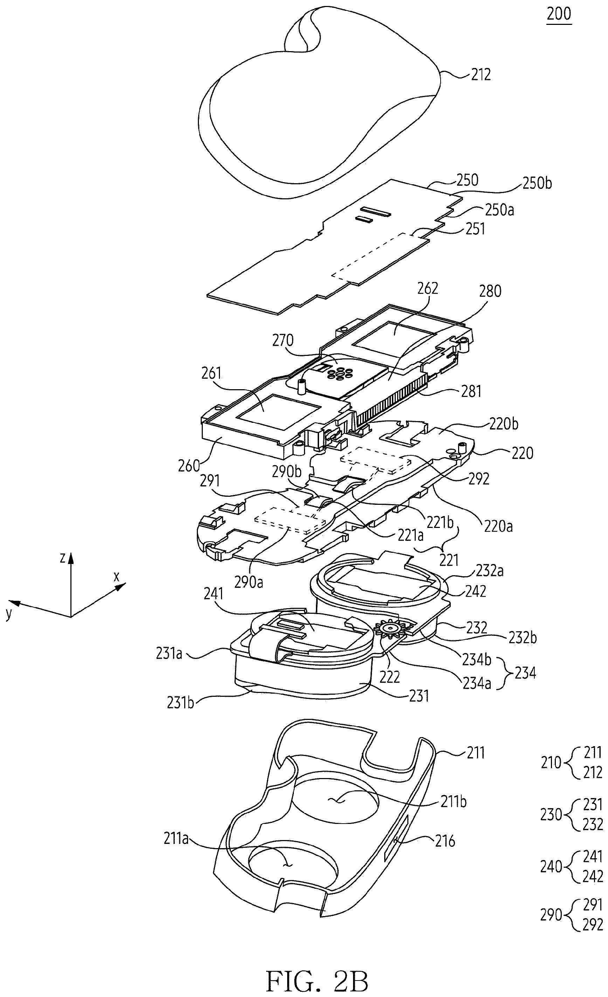

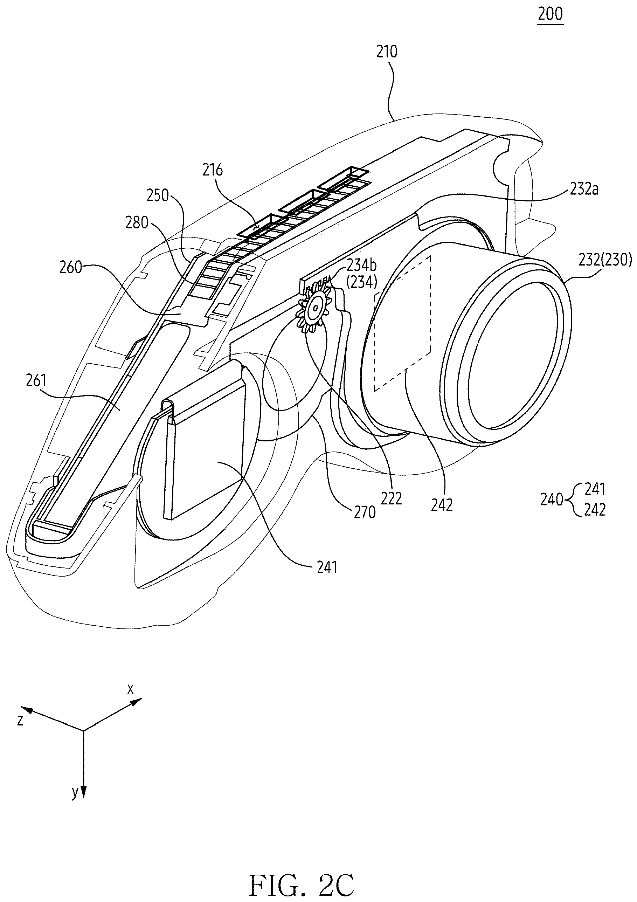

FIG. 2A is a perspective view of an exemplary electronic device according to an embodiment, FIG. 2B is an exploded perspective view of an exemplary electronic device according to an embodiment, and FIG. 2C is a partial cross-sectional view illustrating an example of an exemplary electronic device according to an embodiment, cut along line A-A' of FIG. 2A.

Referring to FIGS. 2A, 2B, and 2C, an electronic device 200 (e.g., the electronic device 101 of FIG. 1) according to an embodiment may include a housing 210, a first bracket 220, at least one moving flange 230, at least one display 240, a printed circuit board 250, a second bracket 260, a fan 270, a heat sink 280, and/or at least one heat dissipation member 290. According to an embodiment, the electronic device 200 may be referred to as a wearable device worn on a part of a body of a user. The electronic device 200 may be configured to provide an augmented reality (AR), a virtual reality (VR), or a mixed reality (MR) in which the augmented reality and the virtual reality are mixed to the user. For example, the electronic device 200 may be configured to provide the virtual reality through the at least one display 240 based on receiving data related to an image from the outside of the electronic device 200. For example, the image provided by the electronic device 200 may include a still image and a video for implementing the virtual reality. For example, the electronic device 200 may be configured to provide the augmented reality through the at least one display 240 overlappingly displaying a virtual object on a reality image provided by light received from the outside of the electronic device 200. The reality image may mean an image or a video implemented by the light received from the outside of the electronic device 200 without separate data processing by the electronic device 200. The virtual object may include at least one of text and an image corresponding to various information related to an object included in the reality image. However, it is not limited thereto, and the virtual object may include the at least one of text and image corresponding to various information related to another object distinguished from the object included in the reality image.

The housing 210 may define at least a portion of an outer surface of the electronic device 200. The housing 210 may accommodate various components of the electronic device 200. The housing 210 may surround the various components of the electronic device 200. According to an embodiment, a first surface 210a of the housing 210 may face the part of the body of the user, when the electronic device 200 is worn by the user. For example, the housing 210 may include the first surface 210a, a second surface 210b, and/or a lateral surface 210c. The first surface 210a of the housing 210 may face a face of the user, when the electronic device 200 is worn on a head. The second surface 210b of the housing 210 may be opposite to the first surface 210a of the housing 210. The second surface 210b may be spaced apart from the first surface 210a. A direction (e.g., +z direction) toward which the second surface 210b faces may face a direction opposite to a direction (e.g., -z direction) toward which the first surface 210a faces. For example, the direction toward which the second surface 210b faces may be substantially parallel to a gaze direction of the user, when the electronic device 200 is worn by the user. According to an embodiment, the lateral surface 210c of the housing 210 may connect the first surface 210a and the second surface 210b. The lateral surface 210c may extend between the first surface 210a and the second surface 210b. The lateral surface 210c may surround a periphery of the first surface 210a and a periphery of the second surface 210b. According to an embodiment, the lateral surface 210c of the housing 210 may may be bent with a curvature, but is not limited thereto. For example, the lateral surface 210c may be perpendicular to the first surface 210a and the second surface 210b.

According to an embodiment, the housing 210 may include a first case 211 and a second case 212. The first case 211 and the second case 212 may be coupled to each other to define (or form) the housing 210. The first case 211 may define the first surface 210a of the housing 210. According to an embodiment, the first case 211 may include a first driving hole 211a and a second driving hole 211b. The first driving hole 211a and the second driving hole 211b may define a space in which the at least one moving flange 230 may move. For example, the first driving hole 211a may define a space in which a first moving flange 231 may move. For example, the second driving hole 211b may define a space in which a second moving flange 232 may move. According to an embodiment, the first driving hole 211a and the second driving hole 211b may penetrate the first case 211. The first driving hole 211a and the second driving hole 211b may be spaced apart from each other. According to an embodiment, a size of each of the first driving hole 211a and the second driving hole 211b may be larger than a size of each of the first moving flange 231 and the second moving flange 232. For example, a size of a cross-sectional area of each of the first driving hole 211a and the second driving hole 211b may be larger than a size of a cross-sectional area of each of the first moving flange 231 and the second moving flange 232. The second case 212 may define the second surface 210b of the housing 210. According to an embodiment, the lateral surface 210c of the housing 210 may be defined by coupling of the first case 211 and the second case 212.

According to an embodiment, the housing 210 may include a nose pad 213. The nose pad 213 may support the electronic device 200 by contacting to the part of the body of the user when the electronic device 200 is worn by the user. The nose pad 213 may have a shape corresponding to a shape of the part of the body of the user. For example, the nose pad 213 may contact a nose of the user, when electronic device 200 is worn on the head of the user. According to an embodiment, the electronic device 200 may be symmetrical a left-right direction (e.g., x-axis direction) with respect to the nose pad 213.

According to an embodiment, the housing 210 may include a first inlet 214, a second inlet 215, and an outlet 216. The first inlet 214 may connect the outside of the housing 210 and the inside of the housing 210. The first inlet 214 may transfer air from the outside of the housing 210 to the inside of the housing 210. According to an embodiment, the first inlet 214 may penetrate the first surface 210a of the housing 210. The first inlet 214 may be disposed on the first surface 210a. The number of first inlets 214 may be one or more. The second inlet 215 may connect the outside of the housing 210 and the inside of the housing 210. The second inlet 215 may transfer air from the outside of the housing 210 to the inside of the housing 210. According to an embodiment, the second inlet 215 may penetrate the lateral surface 210c of the housing 210. The second inlet 215 may be disposed on the lateral surface 210c. The number of second inlets 215 may be one or more. The outlet 216 may connect the outside of the housing 210 and the inside of the housing 210. The outlet 216 may transfer air from the inside of the housing 210 to the outside of the housing 210. For example, the outlet 216 may transfer the air passing through the heat sink 280 to the outside of the housing 210. According to an embodiment, at least a portion of the outlet 216 may overlap the heat sink 280 when viewed from above. For example, the outlet 216 may penetrate the lateral surface 210c of the housing 210. For example, the outlet 216 may be disposed on the lateral surface 210c of the housing 210. The number of outlets 216 may be one or more.

The first bracket 220 may support a portion of the components of the electronic device 200 in the housing 210. According to an embodiment, the first bracket 220 may be disposed in the housing 210. For example, the first bracket 220 may be disposed between the at least one moving flange 230 and the second bracket 260. According to an embodiment, a surface 220a of the first bracket 220 may face the at least one display 240. Another surface 220b of the first bracket 220 may be opposite to the surface 220a of the first bracket 220. A direction (e.g., +z direction) toward which the other surface 220b of the first bracket 220 faces may opposite to a direction (e.g., -z direction) toward which the surface 220a of the first bracket 220 faces. The other surface 220b of the first bracket 220 may be spaced apart from the surface 220a of the first bracket 220.

According to an embodiment, the first bracket 220 may include at least one through hole 221. The at least one through hole 221 may penetrate the first bracket 220. The at least one through hole 221 may extend between the surface 220a of the first bracket 220 and the other surface 220b of the first bracket 220. According to an embodiment, the at least one through hole 221 may include a first through hole 221a and a second through hole 221b. The second through hole 221b may be spaced apart from the first through hole 221a.

According to an embodiment, the electronic device 200 may include a pinion gear 222 coupled to the first bracket 220. The pinion gear 222 may be rotatable with respect to the first bracket 220. The pinion gear 222 may include a plurality of gears. The pinion gear 220 may face the surface 220a of the first bracket 220. The pinion gear 222 may be disposed on the surface 220a of the first bracket 220. When an element is referred to as being "on" of another element, it should be understood that it may be directly on the other element or that intervening elements may exist therebetween. In contrast, when the element is referred to as being "directly on" the other element, intervening elements are absent.

The at least one moving flange 230 may be coupled to the housing 210 to be movable with respect to the housing 210. For example, the at least one moving flange 230 may be movable with respect to the first bracket 220 in the housing 210. According to an embodiment, the at least one moving flange 230 may include a first moving flange 231 and a second moving flange 232. The first moving flange 231 may pass through the first driving hole 211a. For example, the first moving flange 231 may pass through the first driving hole 211a by extending from the inside of the housing 210. The second moving flange 232 may pass through the second driving hole 211b. For example, the second moving flange 232 may pass through the second driving hole 211b by extending from the inside of the housing 210. According to an embodiment, a portion of the moving flange 230 may be disposed in the housing 210. For example, the portion of the moving flange 230 may be coupled to the at least one display 240 in the housing 210. For example, a portion 231a of the first moving flange 231 may be coupled to a first display 241 in the housing 210. For example, a portion 232a of the second moving flange 232 may be coupled to a second display 242 in the housing 210. According to an embodiment, the portion of the moving flange 230 may face the first bracket 220. For example, the portion 231a of the first moving flange 231 may face the surface 220a of the first bracket 220. For example, the portion 232a of the second moving flange 232 may face the surface 220a of the first bracket 220. According to an embodiment, another portion of the moving flange 230 may be disposed outside the housing 210. For example, another portion 231b of the first moving flange 231 may be disposed outside the housing 210. For example, another portion 232b of the second moving flange 232 may be disposed outside the housing 210. According to an embodiment, the other portion 231b of the first moving flange 231 may protrude to the outside of the housing 210. For example, the other portion 231b of the first moving flange 231 may penetrate the first driving hole 211a. For example, the other portion 231b of the first moving flange 231 may be disposed outside the first driving hole 211a. According to an embodiment, the other portion 232b of the second moving flange 232 may protrude to the outside of the housing 210. For example, the other portion 232b of the second moving flange 232 may penetrate the second driving hole 211b. For example, the other portion 232b of the second moving flange 232 may be disposed outside the second driving hole 211b.

According to an embodiment, the at least one moving flange 230 may include a lens 233. The lens 233 may refract light dissipated from the at least one display 240 so that the electronic device 200 may provide the virtual reality. According to an embodiment, the lens 233 may be coupled to another portion 230b of the at least one moving flange 230 disposed outside the housing 210. The lens 233 may face the body of the user, when the electronic device 200 is worn by the user. For example, the lens 233 may face eyes of the user, when the electronic device 200 is worn on the head of the user. According to an embodiment, the lens 233 may include a plurality of lenses disposed on each of the first moving flange 231 and the second moving flange 232.

According to an embodiment, the at least one moving flange 230 may include a rack gear 234. The rack gear 234 may include the plurality of gears. The rack gear 234 may be engaged with the pinion gear 222. Teeth of the plurality of gears of the rack gear 234 may be engaged with teeth of a plurality of gears of the pinion gear 222. In an embodiment, the rack gear 234 may be disposed in the housing 210. For example, the rack gear 234 may be disposed in a portion 230a of the at least one moving flange 230. According to an embodiment, the rack gear 234 may include a first rack gear 234a and a second rack gear 234b. The first rack gear 234a may be coupled to the first moving flange 231. The second rack gear 234b may be coupled to the second moving flange 232. According to an embodiment, the rack gear 234 may have a shape extending in a direction (e.g., +x direction or -x direction) parallel to the surface 220a of the first bracket 220. For example, the first rack gear 234a and the second rack gear 234b may be parallel to the surface 220a of the first bracket 220.

The at least one display 240 may be configured to provide visual information. For example, the at least one display 240 may be configured to dissipate light based on receiving data for displaying an image from a processor (e.g., the processor 120 of FIG. 1). According to an embodiment, the at least one display 240 may be electrically connected to the printed circuit board 250. For example, the at least one display 240 may be electrically connected to the printed circuit board 250 through a flexible printed circuit board. According to an embodiment, the at least one display 240 may be coupled to the at least one moving flange 230. For example, the at least one display 240 may be disposed in the portion 230a of the at least one moving flange 230 disposed in the housing 210. According to an embodiment, the at least one display 240 may include the first display 241 and the second display 242. The first display 241 may be coupled to the first moving flange 231. The first display 241 may be disposed on the surface 220a of the first bracket 220. The first display 241 may face the surface 220a of the first bracket 220. The first display 241 may be spaced apart from the surface 220a of the first bracket 220. The second display 242 may be coupled to the second moving flange 232. The second display 242 may be disposed on the surface 220a of the first bracket 220. The second display 242 may be spaced apart from the surface 220a of the first bracket 220.

According to an embodiment, the at least one display 240 may be movable in the housing 210. The at least one display 240 may be movable with respect to the first bracket 220. For example, the at least one display 240 may be movable on the surface 220a of the first bracket 220. For example, the at least one display 240 may be movable in a direction parallel to the surface 220a of the first bracket 220. According to an embodiment, the second display 242 may move in a direction (e.g., -x direction) approaching the first display 241 or a direction (e.g., +x direction) away from the first display 241. According to an embodiment, the at least one display 240 may be movable with respect to the first bracket 220 by a movement of the at least one moving flange 230 with respect to the first bracket 220. For example, the user may move the at least one moving flange 230 through the other portion 230b of the at least one moving flange 230. According to an embodiment, a distance between the first display 241 and the second display 242 may be decreased or increased by a movement of the first moving flange 231 and the second moving flange 232. For example, in case that the first moving flange 231 moves in a direction (e.g., +x direction) approaching the second moving flange 232 by an external force of the user, the pinion gear 222 engaged with the first rack gear 234a may rotate. By the rotation of the pinion gear 222, the second rack gear 234b engaged with the pinion gear 222 may move in a direction (e.g., -x direction) approaching the first moving flange 231. As the first moving flange 231 moves in the direction approaching the second moving flange 232 and the second moving flange 232 moves in the direction approaching the first moving flange 231, the distance between the first display 241 and the second display 242 may decrease. For example, in case that the first moving flange 231 moves in a direction (e.g., -x direction) away from the second moving flange 232 by the external force of the user, the pinion gear 222 engaged with the first rack gear 234a may rotate. By the rotation of the pinion gear 222, the second rack gear 234b engaged with the pinion gear 222 may move in a direction (e.g., +x direction) away from the first moving flange 231. As the first moving flange 231 moves in the direction away from the second moving flange 232 and the second moving flange 232 moves in the direction away from the first moving flange 231, the distance between the first display 241 and the second display 242 may increase. Through the at least one moving flange 230, the distance between the first display 241 and the second display 242 may correspond to an inter-pupillary distance of the user. As the distance between the first display 241 and the second display 242 is adjusted to correspond to the inter-pupillary distance, the electronic device 200 may provide a three-dimensional virtual reality to the user.

The printed circuit board 250 may form an electrical connection between components in the electronic device 200. For example, the printed circuit board 250 may form an electrical connection between electronic components disposed on a surface 250a of the printed circuit board 250 or another surface 250b of the printed circuit board 250 opposite to the surface 250a of the printed circuit board 250. The printed circuit board 250 may form an electrical connection between other electronic components disposed outside the printed circuit board 250. The printed circuit board 250 may form an electrical connection between the electronic components (e.g., the processor 120 of FIG. 1) disposed on the surface 250a of the printed circuit board 250 and the other electronic components disposed outside the printed circuit board 250. For example, the printed circuit board 250 may be electrically connected to the at least one display 241. According to an embodiment, the printed circuit board 250 may be disposed in the housing 210. For example, the printed circuit board 250 may be disposed on the other surface 220b of the first bracket 220. For example, the printed circuit board 250 may be spaced apart from the other surface 220b of the first bracket 220 along the direction (e.g., +z direction) toward which the other surface 220b of the first bracket 220 faces. The surface 250a of the printed circuit board 250 may face the second bracket 260.

The second bracket 260 may support another portion of the components of the electronic device 200. For example, the second bracket 260 may support a first battery 261 and a second battery 262. The first battery 261 may be coupled to the second bracket 260. The second battery 262 may be spaced apart from the first battery 261 and coupled to the second bracket 260. According to an embodiment, the second bracket 260 may surround the first battery 261 and the second battery 262. The first battery 261 and the second battery 262 may be electrically connected to the printed circuit board 250. According to an embodiment, the second bracket 260 may be disposed in the housing 210. For example, the second bracket 260 may be disposed between the printed circuit board 250 and the first bracket 220.

The fan 270 may generate airflow for cooling the housing 210 and components located inside the housing 210. For example, the fan 270 may generate airflow for introducing air outside the housing 210 into the inlets 214 and 215 of the housing 210. The fan 270 may generate airflow for emitting the air inside the housing 210 to the outlet 216 of the housing 210. According to an embodiment, the fan 270 may be electrically connected to the printed circuit board 250. The fan 270 may be electrically connected to at least one of the first battery 261 and the second battery 262. The fan 270 may receive power from the at least one of the first battery 261 and the second battery 262. According to an embodiment, the fan 270 may be coupled to the second bracket 260. For example, the fan 270 may be disposed between the first battery 261 and the second battery 262. According to an embodiment, the fan 270 may be disposed between the printed circuit board 250 and the first bracket 220. The fan 270 may face the first bracket 220. For example, the fan 270 may face the other surface 220b of the first bracket 220. According to an embodiment, the fan 270 may face the at least one through hole 221 of the first bracket 220. For example, the fan 270 may face the first through hole 221a and the second through hole 221b. For example, the at least one through hole 221 may at least partially overlap the fan 270 when the first bracket 220 is viewed vertically (e.g., -z direction).

The heat sink 280 may dissipate heat generated from the printed circuit board 250 to the outside of the housing 210. For example, it may include a plurality of pins 281 for increasing a surface area of the inside of the heat sink 280. According to an embodiment, the heat sink 280 may face the surface 250a of the printed circuit board 250. For example, the heat sink 280 may face a portion (e.g., the processor 120 of FIG. 1) of electronic components disposed on the surface 250a of the printed circuit board 250. According to an embodiment, a region 251 of the printed circuit board 250 may face the heat sink 280. For example, the region 251 of the printed circuit board 250 may at least partially overlap the heat sink 280 when the printed circuit board 250 is viewed vertically (e.g., +z direction or -z direction). According to an embodiment, in the region 251 of the printed circuit board 250, electronic components having relatively high heat generation among a plurality of electronic components disposed in the printed circuit board 250 may be disposed . For example, the electronic component disposed in the first region 251 of the printed circuit board 250 may include the processor 120. As the heat sink 280 faces the region 251 of the printed circuit board 250, heat generated from the electronic components of the printed circuit board 250 may be dissipated to the outside of the housing 210.

According to an embodiment, the heat sink 280 may pass through the airflow generated by the fan 270. The heat sink 280 may dissipate heat transferred from the airflow generated by the fan 270 to the outside of the housing 210. According to an embodiment, the heat sink 280 may be coupled to the second bracket 260. For example, the heat sink 280 may be disposed between the first battery 261 and the second battery 262. According to an embodiment, the heat sink 280 may at least partially overlap the fan 270 when the housing 210 is viewed from above (e.g., -y direction).

According to an embodiment, the air outside the housing 210 may be introduced into the housing 210 through the inlets 214 and 215 by the airflow generated through the fan 270. The Air introduced into the housing 210 through the inlets 214 and 215 may be transferred to the components (e.g., the at least one display 240 and/or the printed circuit board 250) in the housing 210. The heat generated in the housing 210 may be transferred to the air introduced into the housing 210. The air heated in the housing 210 may move to the fan 270. As air passes through the heat sink 280 and the outlet 216 and is emitted to the outside of the housing 210, the inside of the housing 210 may be cooled.

The at least one heat dissipation member 290 may cool the inside of the housing 210. For example, the at least one heat dissipation member 290 may transfer the heat generated from the at least one display 240 to the fan 270. According to an embodiment, the at least one heat dissipation member 290 may be coupled to the at least one display 240 and the first bracket 220. According to an embodiment, the at least one heat dissipation member 290 may pass through the at least one through hole 221. For example, the at least one heat dissipation member 290 may extend from a surface of the at least one display 240 facing the surface 220a of the first bracket 220. The at least one heat dissipation member 290 may pass through the at least one through hole 221 and extend to the other surface 220b of the first bracket 220. For example, the at least one heat dissipation member 290 may include at least one of graphite and metal, but is not limited thereto.

According to an embodiment, the at least one heat dissipation member 290 may include a first heat dissipation member 291 and a second heat dissipation member 292. The first heat dissipation member 291 may be disposed on a surface of the first display 241 facing the surface 220a of the first bracket 220. For example, the first heat dissipation member 291 may contact the first moving flange 231. The first heat dissipation member 291 may pass through the first through hole 221a. The second heat dissipation member 292 may be disposed on a surface of the second display 242 facing the surface 220a of the first bracket 220. For example, the second heat dissipation member 291 may contact the second moving flange 232. The second heat dissipation member 292 may pass through the second through hole 221b. According to an embodiment, the first heat dissipation member 291 may be spaced apart from the second heat dissipation member 292. For example, the first heat dissipation member 291 and the second heat dissipation member 292 may be disconnected from each other. However, it is not limited thereto, and the first heat dissipation member 291 and the second heat dissipation member 292 may be connected to each other or may be integrally formed.

According to an embodiment, the at least one heat dissipation member 290 may include a first region 290a and a second region 290b. The first region 290a may be attached to the surface of the at least one display 240 facing the surface 220a of the first bracket 220. According to an embodiment, a size of the first region 290a may correspond to a size of the surface of the at least one display 240 facing the surface 220a of the first bracket 220. For example, an area of the first region 290a may correspond to an area of the surface of the at least one display 240 facing the surface 220a of the first bracket 220. However, it is not limited thereto, and according to embodiments, the area of the first region 290a may be larger than the area of the at least one display 240. For example, the area of the first region 290a may have a size corresponding to a cross section of the at least one moving flange 230. The second region 290b may be disposed on the other surface 220b of the first bracket 220. The second region 290b may be attached to the other surface 220b of the first bracket 220. According to an embodiment, the second region 290b may face the fan 270. For example, the second region 290b may at least partially overlap the fan 270 when the first bracket 220 is viewed vertically (e.g., +z direction or -z direction).

According to an embodiment, the at least one heat dissipation member 290 may transfer heat emitted from the at least one display 240 to the other surface 220b of the first bracket 220. For example, the heat emitted from the at least one display 240 may pass through the at least one through hole 221 through the at least one heat dissipation member 290. The heat passing through the at least one through hole 221 may be conducted to the other surface 220b of the first bracket 220 through the at least one heat dissipation member 290. The heat conducted to the other surface 220b of the first bracket 220 may be dissipated to the outside of the housing 210 by the airflow generated by the fan 270 facing the other surface 220b of the first bracket 220. For example, in case that the at least one heat dissipation member 290 is omitted, the heat emitted from the at least one display 240 may only be emitted by the airflow generated by the fan 270. The electronic device 200 according to an embodiment may provide a structure capable of dissipating heat generated by the display 240 to the outside of the housing 210 through conduction by the at least one heat dissipation member 290 attached to the at least one surface of display 240.

According to an embodiment, the at least one heat dissipation member 290 may penetrate the at least one through hole 221. As the at least one heat dissipation member 290 penetrates the at least one through hole 221, the at least one heat dissipation member 290 may rapidly transfer the heat emitted from the at least one display 240 to the fan 270. For example, in case that the at least one heat dissipation member 290 does not pass through the at least one through hole 221, the at least one heat dissipation member 290 may be disposed only on the surface 220a of the first bracket 220. In case that the at least one heat dissipation member 290 is disposed only on the surface 220a of the first bracket 220, the heat emitted from the at least one display 240 may be conducted to the entire first bracket 220 by the at least one heat dissipation member 290. In case that the heat is conducted to the entire first bracket 220, the heat may not be rapidly dissipated to the outside of the housing 210. The electronic device 200 according to an embodiment may provide a structure capable of rapidly dissipating the heat emitted from the at least one display 240 to the outside of the housing 210 by the at least one heat dissipation member 290 passing through the at least one through hole 221. For example, since the second region 290b of the at least one heat dissipation member 290 faces the fan 270 on the other surface 220b of the first bracket 220, the heat emitted from the at least one display 240 may be rapidly dissipated to the outside of the housing 210 through the fan 270.

According to an embodiment, the at least one heat dissipation member 290 may transfer heat to the at least one moving flange 230. For example, the at least one heat dissipation member 290 may transfer the heat emitted from the at least one display 240 to the portion 230a of the at least one moving flange 230 surrounding the at least one display 240. For example, the heat transferred to the at least one heat dissipation member 290 may be transferred to the at least one moving flange 230 in contact with the at least one heat dissipation member 290. For example, the heat transferred to the at least one heat dissipation member 290 may be transferred to the at least one moving flange 230 spaced apart from the at least one heat dissipation member 290. The at least one heat dissipation member 290, which transfers the heat to the at least one moving flange 230, may prevent the heat from concentrating on the at least one display 240.

As described above, the electronic device 200 according to an embodiment may provide a structure capable of rapidly dissipating the heat generated from the at least one display 240 to the outside of the housing 210, through the first region 290a of the at least one heat dissipation member 290 attached to the surface of the at least one display 240. The electronic device 200 according to an embodiment may provide a structure capable of rapidly dissipating the heat generated from the at least one display 240 to the outside of the housing 210, through the second region 290b of the at least one heat dissipation member 290 facing the fan 270.

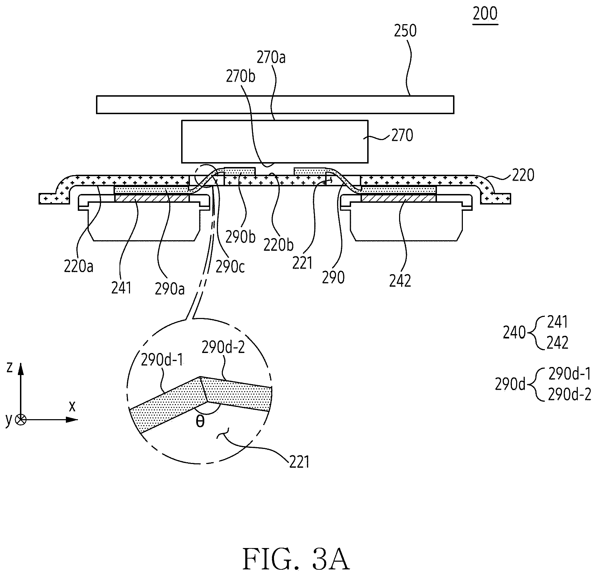

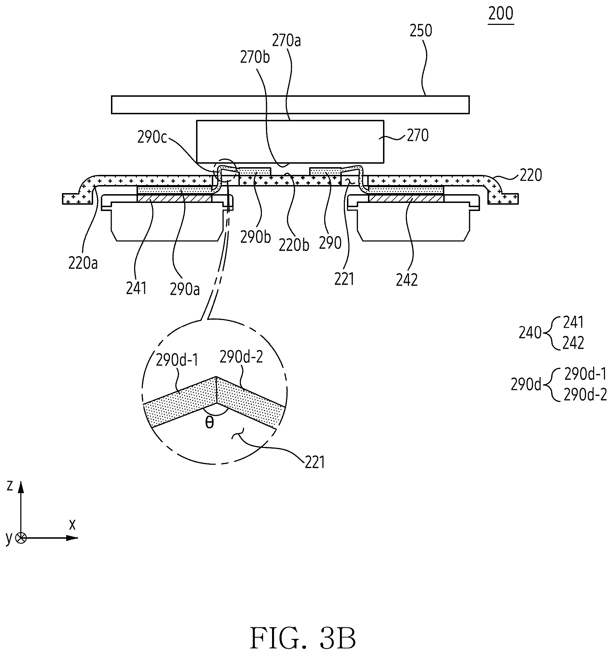

FIG. 3A is a cross-sectional view illustrating an example of an exemplary electronic device according to an embodiment, cut along line B-B' of FIG. 2A, and FIG. 3B is a cross-sectional view illustrating an example of an exemplary electronic device according to an embodiment, cut along line B-B' of FIG. 2A.

Referring to FIGS. 3A and 3B, according to an embodiment, a printed circuit board 250 may face a surface 270a of a fan 270. Another surface 270b of the fan 270 opposite to the surface 270a of the fan 270 may face a second region 290b of at least one heat dissipation member 290.

According to an embodiment, a portion 290c of the at least one heat dissipation member 290 may be disposed in at least one through hole 221. The portion 290c of the at least one heat dissipation member 290 may be disposed between a first region 290a and the second region 290b. the portion 290c of the at least one heat dissipation member 290 may connect the first region 290a and the second region 290b. The portion 290c of the at least one heat dissipation member 290 may pass through the at least one through hole 221. For example, heat generated by at least one display 240 may be transferred to the first region 290a attached to a surface of the at least one display 240. The heat transferred to the first region 290a may be transferred to the second region 290b through the portion 290c of the at least one heat dissipation member 290. The heat transferred to the second region 290b facing the other surface 270b of the fan 270 may be dissipated to the outside of a housing (e.g., the housing 210 of FIGS. 2A, 2B, and 2C) through airflow generated by the fan 270.

According to an embodiment, the portion 290c of the at least one heat dissipation member 290 may be deformable in the at least one through hole 221 according to a movement of the at least one display 240 with respect to a first bracket 220. For example, the portion 290c of the at least one heat dissipation member 290 may be deformable according to a movement of a first display 241 with respect to the first bracket 220. For example, the portion 290c of the at least one heat dissipation member 290 may be bent in the at least one through hole 221, but is not limited thereto. According to an embodiment, the portion 290c of the at least one heat dissipation member 290 may be foldable in the at least one through hole 221. For example, in case that a distance between the first display 241 and a second display 242 decreases by the movement of the first display 241 with respect to the first bracket 220, the portion 290c of the at least one heat dissipation member 290 may be folded. For example, in case that the distance between the first display 241 and the second display 242 increases by the movement of the first display 241 with respect to the first bracket 220, the portion 290c of the at least one heat dissipation member 290 may be unfolded. For example, in case that the at least one heat dissipation member 290 is not deformable, the at least one heat dissipation member 290 may be damaged by the movement of the at least one display 240 with respect to the first bracket 220. Since the at least one heat dissipation member 290 is deformable, an electronic device 200 according to an embodiment may provide a structure capable of reducing damage to the at least one heat dissipation member 290 by the movement of the at least one display 240.

According to an embodiment, the portion 290c of the at least one heat dissipation member 290 may include a plurality of extending portions 290d. The plurality of extending portions 290d may be connected to each other. A shape of the plurality of extending portions 290d may be deformed by the movement of at least one display 240 with respect to the first bracket 220. An angle θ between the plurality of extending portions 290d may be changed by the movement of the at least one display 240 with respect to the first bracket 220. For example, the plurality of extending portions 290d may include a first extending portion 290d-1 and a second extending portion 290d-2, disposed in a first through hole 221a. For example, in case that the distance between the first display 241 and the second display 242 decreases (e.g., FIG. 3B), the angle θ between the first extending portion 290d-1 and the second extending portion 290d-2 connected to each other may decrease. For example, in case that the distance between the first display 241 and the second display 242 increases (e.g., FIG. 3A), the angle θ between the first extending portion 290d-1 and the second extending portion 290d-2 connected to each other may increase. According to an embodiment, as the portion 290c of the at least one heat dissipation member 290 includes the plurality of extending portions 290a, the portion 290c of the at least one heat dissipation member 290 may have a shape including a wrinkle.

As described above, the electronic device 200 according to an embodiment may provide a robust structure against damage caused by the at least one display 240 by the at least one deformable heat dissipation member 290.

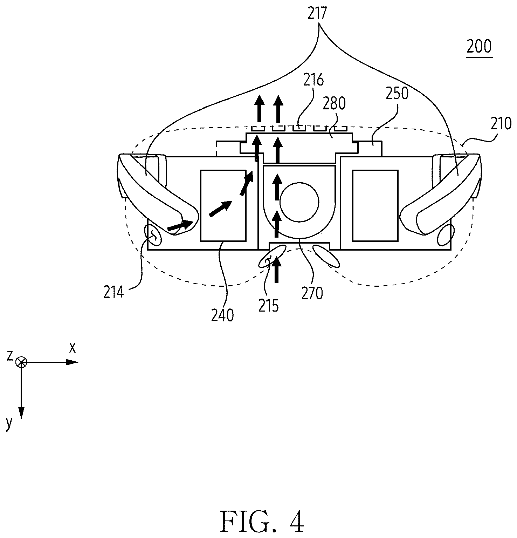

FIG. 4 is a rear view of an exemplary electronic device according to an embodiment.

Referring to FIG. 4, according to an embodiment, a housing 210 may include a plurality of temples 217. The plurality of temples 217 may support an electronic device 200. The plurality of temples 217 may contact a part of a body of a user, when the electronic device 200 is worn by the user. When the electronic device 200 is worn on a head of the user, the plurality of temples 217 may contact an ear of the user.

According to an embodiment, air outside the housing 210 may pass through at least one first inlet 214 by airflow generated by a fan 270. The air introduced through the at least one first inlet 214 may cool at least one display 240 by passing through the at least one display 240. The air passing through the at least one display 240 may pass through a heat sink 280. The air passing through the heat sink 280 may be emitted to the outside of the housing 210 through at least one outlet 216.

According to an embodiment, the air outside the housing 210 may pass through at least one second inlet 215 by the airflow generated by the fan 270. The air introduced through the second inlet 215 may pass through the fan 270. The air passing through the fan 270 may pass through the heat sink 280 by the airflow generated by the fan 270. The air passing through the heat sink 280 may be emitted to the outside of the housing 210 through the at least one outlet 216.

As described above, the electronic device 200 according to an embodiment may provide a structure capable of dissipating heat generated by the at least one display 240 and a printed circuit board 250 to the outside of the housing 210 through the fan 270.

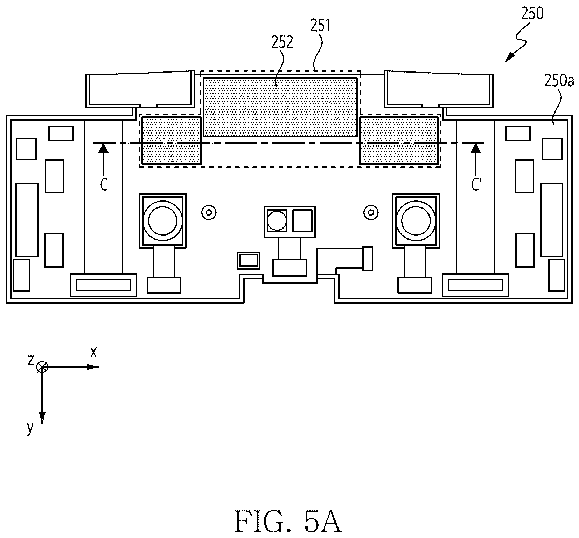

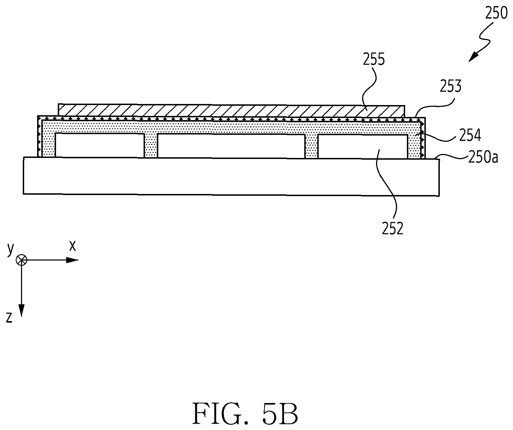

FIG. 5A is a top plan view of a printed circuit board of an exemplary electronic device according to an embodiment, and FIG. 5B is a cross-sectional view illustrating an example of a printed circuit board of an exemplary electronic device according to an embodiment, cut along line C-C' of FIG. 5A.

Referring to FIGS. 5A and 5B, according to an embodiment, a printed circuit board 250 may include a plurality of electronic components 252. The plurality of electronic components 252 may be disposed on a surface 250a of the printed circuit board 250. For example, the plurality of electronic components 252 may protrude from the surface 250a of the printed circuit board 250. According to an embodiment, the plurality of electronic components 252 may implement various functions of an electronic device (e.g., the electronic device 200 of FIGS. 2A, 2B, and 2C). For example, the plurality of electronic components 252 may include a processor (e.g., the processor 120 of FIG. 1) that is disposed on the surface 250a of the printed circuit board 250 and controls an overall operation of the electronic device 200.

According to an embodiment, the printed circuit board 250 may include a shield can 253, a thermal conduction material 254, and/or an emission member 255. The shield can 253 may shield an electromagnetic wave transmitted to the plurality of electronic components 252. The shield can 253 may shield the electromagnetic wave dissipated from the plurality of electronic components 252. For example, the shield can 253 may be electrically connected to a ground of the printed circuit board 250. The shield can 253 may include a conductive material, but is not limited thereto. According to an embodiment, the shield can 253 may be disposed on the surface 250a of the printed circuit board 250. For example, the shield can 253 may surround the plurality of electronic components 252. For example, the shield can 253 may surround the plurality of electronic components 252 disposed in a region 251 of the printed circuit board 250. According to an embodiment, the shield can 253 may be spaced apart from the plurality of electronic components 252. For example, a gap may be formed a space between the plurality of electronic components 252 and the shield can 253.

The thermal conduction material 254 may transfer heat generated by the plurality of electronic components 252 to the shield can 253. According to an embodiment, the thermal conduction material 254 may fill the gap between the plurality of electronic components 252 and the shield can 253. For example, the thermal conduction material 254 may be in contact with the plurality of electronic components 252 and the shield can 253. For example, the thermal conduction material 254 may surround the plurality of electronic components 252 and the shield can 253. According to an embodiment, the thermal conduction material 254 may be made of a material having high thermal conductivity. For example, the thermal conduction material 254 may include thermal interface material (TIM), but is not limited thereto. For example, in case that the thermal conduction material 254 is omitted, the heat generated from the plurality of electronic components 252 may not be rapidly dissipated to the outside of the shield can 253 by the gap between the plurality of electronic components 252 and the shield can 253. The electronic device 200 according to an embodiment may provide a structure capable of rapidly dissipating the heat generated from the plurality of electronic components 252 to the outside of the electronic device 200 through the thermal conduction material 254 filling the gap between the plurality of electronic components 252 and the shield can 253.

The emission member 255 may dissipate the heat transferred to the shield can 253 to the outside of the shield can 253. For example, the emission member 255 may transfer the heat transferred to the shield can 253 through the thermal conduction material 254 to a heat sink 280. According to an embodiment, the emission member 255 may be made of a material having high thermal conductivity. For example, the emission member 255 may include graphite, but is not limited thereto. According to an embodiment, the emission member 255 may be disposed on an outer surface of the shield can 253. For example, the outer surface of the shield can 253 may be opposite to an inner surface of the shield can 253 facing the plurality of electronic components 252. For example, the outer surface of the shield can 253 may face the heat sink 280. The heat generated by the plurality of electronic components 252 may be transferred to the shield can 253 through the thermal conduction material 254. The heat transferred to the shield can 253 may be transferred to the emission member 255 disposed on the outer surface of the shield can 253. The heat transferred to the emission member 255 may be dissipated to the outside of the electronic device 200 through the heat sink 280.

As described above, the electronic device 200 according to an embodiment may provide a structure capable of rapidly dissipating the heat generated from the plurality of electronic components 252 to the outside of the electronic device 200, through the thermal conduction material 254 in contact with the plurality of electronic components 252 and the shield can 253. The electronic device 200 according to an embodiment may provide the structure capable of rapidly dissipating the heat generated from the plurality of electronic components 252 to the outside of the electronic device 200 through the emission member 255 disposed on the outer surface of the shield can 253.

The electronic device may provide visual information to the user in a state of being worn by the user. For example, the electronic device may include a plurality of displays corresponding to both eyes of the user. The plurality of displays may be movable with respect to each other so that the electronic device may provide three-dimensional visual information to the user. Since the heat generated as the plurality of displays operate may interfere with the operation of the plurality of displays, the electronic device may require a structure for dissipating the heat generated inside the electronic device to the outside of the electronic device.

An electronic device (e.g., the electronic device 200 of FIGS. 2A, 2B, and 2C) according to an embodiment may comprise a housing (e.g., the housing 210 of FIGS. 2A, 2B, and 2C). The electronic device according to an embodiment may comprise a first bracket (e.g., the first bracket 220 of FIG. 2B), including a through hole (e.g., the through hole 221 of FIG. 2B), disposed in the housing. According to an embodiment, the electronic device may comprise a first display (e.g., the first display 241 of FIG. 2B), disposed on a surface (e.g., the surface 220a of FIG. 2B) of the first bracket, configured to be movable with respect to the first bracket. According to an embodiment, the electronic device may comprise a printed circuit board (e.g., the printed circuit board 250 of FIG. 2B) disposed on another surface (e.g., the other surface 220b of FIG. 2B) of the first bracket opposite to the surface of the first bracket. According to an embodiment, the electronic device may comprise a fan (e.g., the fan 270 of FIG. 2B) disposed between the printed circuit board and the first bracket. According to an embodiment, the electronic device may comprise a heat dissipation member (e.g., the heat dissipation member 290 of FIG. 2B) including a first region (e.g., the first region 290a of FIG. 2B) in contact with a surface of the first display facing the surface of the first bracket, and a second region (e.g., the second region 290b of FIG. 2B), in contact with the other surface of the first bracket, facing the fan. According to an embodiment, a portion (e.g., the portion 290c of FIGS. 3A and 3B) of the heat dissipation member, between the first region and the second region, may pass through the through hole and may be configured to be deformable according to movement of the first display with respect to the first bracket.

The electronic device according to an embodiment may provide a structure capable of rapidly dissipating heat generated from at least one display to the outside of the housing through the second region of at least one heat dissipation member facing the fan.

According to an embodiment, the portion of the heat dissipation member may include a plurality of extending portions (e.g., the plurality of extending portions 290d of FIGS. 3A and 3B) connected to each other. According to an embodiment, an angle between the plurality of extending portions may be changed by the movement of the first display with respect to the first bracket.

The electronic device according to an embodiment may provide a robust structure against damage caused by the at least one display by at least one deformable heat dissipation member.

According to an embodiment, an area of the first region may be substantially the same as an area of the surface of the first display.

The electronic device according to an embodiment may provide a structure capable of dissipating heat from the display to the outside of the electronic device by the first region of the at least one heat dissipation member having the same area as an area of at least a surface of the display.

According to an embodiment, the electronic device may comprise a heat sink (e.g., the heat sink 280 of FIG. 2B), disposed between the printed circuit board and the first bracket, including a plurality of pins (e.g., the plurality of pins 281 of FIG. 2B) configured to pass through airflow generated by the fan. According to an embodiment, the housing may comprise at least one outlet (e.g., the outlet 216 of FIG. 2B), corresponding to the heat sink when the housing is viewed from above, transmitting the airflow passing through the heat sink to an outside of the housing.

The electronic device according to an embodiment may provide a structure capable of dissipating heat generated from the printed circuit board to the outside by the heat sink including the plurality of pins.

According to an embodiment, the housing may include a first surface (e.g., the first surface 210a of FIG. 2A) facing a user, when the electronic device is worn by the user. According to an embodiment, the housing may include a first inlet (e.g., the first inlet 214 of FIG. 2A) disposed on the first surface.

The electronic device according to an embodiment may provide a structure capable of introducing airflow for cooling the housing through the first inlet formed in the housing.

According to an embodiment, the housing may include the first surface (e.g., the first surface 210a of FIG. 2A) facing the user, when the electronic device is worn by the user. According to one embodiment, the housing may include a second surface (e.g., the second surface 210b of FIG. 2A), opposite to the first surface, spaced apart from the first surface. According to an embodiment, the housing may include a lateral surface (e.g., the lateral surface 210c of FIG. 2A) connecting the first surface of the housing and the second surface of the housing. According to an embodiment, the housing may include a second inlet (e.g., the second inlet 215 of FIG. 2A) disposed on the lateral surface.

The electronic device according to an embodiment may provide a structure capable of introducing airflow for cooling the housing through the second inlet formed in the housing.

According to an embodiment, the electronic device may include a moving flange (e.g., the moving flange 230 of FIGS. 2A, 2B, and 2C) including a portion (e.g., the portion 230a of FIG. 2B) surrounding the first display in the housing, and another portion (e.g., the other portion 230b of FIG. 2B) protrudes outside the housing. According to an embodiment, the moving flange may include a rack gear (e.g., the rack gear 233 of FIGS. 2B and 2C), disposed in the portion of the moving flange, including a plurality of gears. According to an embodiment, the electronic device may include a pinion gear (e.g., the pinion gear 222 of FIGS. 2B and 2C) that is engaged with the rack gear and rotatable with respect to the first bracket.

The electronic device according to an embodiment may provide a three-dimensional virtual reality to the user by adjusting a distance between the first display and the second display by the moving flange movable with respect to the first bracket.

According to an embodiment, the first region may transfer heat emitted from the surface of the display to the portion of the moving flange surrounding the display.

The electronic device according to an embodiment may provide a structure in which at least one display operates normally by at least one heat dissipation member that transfers heat emitted from at least one display to the moving flange.

According to an embodiment, the moving flange may include a lens (e.g., the lens 233 of FIG. 2A), coupled to the other portion of the moving flange, facing the user's body when the electronic device is worn by the user.

The electronic device according to an embodiment may provide the three-dimensional virtual reality to the user by a lens that refracts light emitted from at least one display.

According to an embodiment, the housing may include at least one driving hole (e.g., the first driving hole 211a and the second driving hole 211b of FIG. 2A) penetrating the housing, and the other portion of the moving flange may be disposed outside the housing according to penetrating the at least one driving hole.

According to an embodiment, the printed circuit board may include an electronic component (e.g., the plurality of electronic components 252 of FIGS. 5A and 5B) disposed on a surface of the printed circuit board facing the fan. According to an embodiment, the printed circuit board may include a shield can (e.g., the shield can 253 of FIG. 5B) surrounding the electronic component. According to an embodiment, the printed circuit board may include a thermal conduction material (e.g., the thermal conduction material 254 of FIG. 5B) filling a gap between the shield can and the electronic component.

The electronic device according to an embodiment may provide a structure capable of rapidly dissipating heat emitted from electronic components to the outside of the printed circuit board by the thermal conduction material filling the gap between the shield can and the electronic component.

According to an embodiment, the printed circuit board may include an emission member (e.g., the emission member 255 of FIG. 5B) disposed on an outer surface of the shield can.

The electronic device according to an embodiment may provide a structure capable of rapidly dissipating heat emitted from the printed circuit board to the outside of the electronic device by the emission member facing the fan in the outside of the shield can.

According to an embodiment, the printed circuit board may include a processor disposed on a surface (e.g., the surface 250a of FIG. 5B) of the printed circuit board facing the fan a processor disposed on the surface of the printed circuit board facing the fan.

According to an embodiment, the electronic device may include a second bracket (e.g., the second bracket 260 of FIGS. 2B and 2C), accommodating the fan, disposed between the printed circuit board and the first bracket. According to an embodiment, the electronic device may include a first battery (e.g., the first battery 261 of FIG. 2B) coupled to the second bracket. According to an embodiment, the electronic device may include a second battery (e.g., the second battery 262 of FIG. 2B), spaced apart from the first battery, coupled to the second bracket. According to an embodiment, the fan may be disposed between the first battery and the second battery.

The electronic device according to an embodiment may provide a structure capable of dissipating heat generated in the housing to the outside of the housing through the fan for circulating air of the inside of the housing.

According to an embodiment, the electronic device may include a second display (e.g., the second display 242 of FIGS. 2B and 2C), spaced apart from the first display, configured to be movable, on the surface of the first bracket, in a direction approaching the first display or in a direction away from the first display.

The electronic device according to an embodiment may provide the three-dimensional virtual reality to the user by adjusting the distance between the first display and the second display by the moving flange movable with respect to the first bracket.

According to an embodiment, the electronic device may include a nose pad (e.g., the nose pad 213 of FIG. 2A) in contact with the part of the body of the user, when the electronic device is worn by the user.

The electronic device according to an embodiment may be supported by the nose pad when the electronic device is worn by the user.

An electronic device (e.g., the electronic device 200 of FIGS. 2A, 2B, and 2C) according to an embodiment may include a housing (e.g., the housing 210 of FIGS. 2A, 2B, and 2C) including a first surface (e.g., the first surface 210a of FIG. 2A) facing a user when the electronic device is worn on the user, and a second surface (e.g., the second surface 210b of FIG. 2A) opposite to the first surface. According to an embodiment, the electronic device may include a first bracket (e.g., the first bracket 220 of FIG. 2B), including a through hole (e.g., the through hole 221 of FIG. 2B), disposed in the housing. According to an embodiment, the electronic device may include a moving flange (e.g., the moving flange 230 of FIGS. 2A, 2B, and 2C) including a portion (e.g., the portion 230a of FIG. 2B) facing a surface (e.g., the surface 220a of FIG. 2B) of the first bracket, and another portion (e.g., the other portion 230b of FIG. 2B) disposed outside the housing, and is rotatable with respect to the first bracket. According to an embodiment, the electronic device may include a first display (e.g., the first display 241 of FIGS. 2B and 2C) coupled to the portion of the moving flange. According to an embodiment, the electronic device may include a fan (e.g., the fan 270 of FIG. 2B) disposed in the housing and facing the other surface (e.g., the other surface 220b of FIG. 2B) of the first bracket opposite to the surface of the first bracket. According to an embodiment, the electronic device may include a printed circuit board (e.g., the printed circuit board 250 of FIG. 2B) disposed between the second surface and the fan. According to an embodiment, the electronic device may include a heat dissipation member (e.g., the heat dissipation member 290 of FIG. 2B) including a first region (e.g., the first region 290a of FIG. 2B) attached to a surface of the first display facing the surface of the first bracket, and a second region (e.g., the second region 290b of FIG. 2B), attached to the other surface of the first bracket, facing the fan. According to an embodiment, a portion (e.g., the portion 290c of FIGS. 3A and 3B) of the heat dissipation member, between the first region and the second region, may pass through the through hole and may be foldable according to movement of the first display with respect to the first bracket.

According to an embodiment, the electronic device may include a heat dissipation member (e.g., the heat dissipation member 290 of FIG. 2B) including a first region (e.g., the first region 290a of FIG. 2B) attached to a surface of the first display facing the surface of the first bracket, and a second region (e.g., the second region 290b of FIG. 2B), attached to the other surface of the first bracket, facing the fan. According to an embodiment, a portion (e.g., the portion 290c of FIGS. 3A and 3B) of the heat dissipation member, between the first region and the second region, may pass through the through hole and may be configured to be deformable according to movement of the first display with respect to the first bracket.

According to an embodiment, an electronic device may comprise a heat sink (e.g., the heat sink 280 of FIG. 2B), disposed between the printed circuit board and the first bracket, including a plurality of pins (e.g., the plurality of pins 281 of FIG. 2B) configured to pass through airflow generated by the fan. According to an embodiment, the housing may include at least one outlet (e.g., the outlet 216 of FIG. 2B), at least partially overlapping the heat sink when the housing is viewed from above, transmitting the airflow passing through the heat sink to an outside of the housing.

According to an embodiment, the electronic device may include a pinion gear (e.g., the pinion gear 222 of FIGS. 2B and 2C) rotatable with respect to the first bracket. According to an embodiment, the moving flange may include a rack gear (e.g., the rack gear 233 of FIGS. 2B and 2C) disposed in the portion of the moving flange.

According to an embodiment, the printed circuit board may include an electronic component (e.g., the plurality of electronic components 252 of FIGS. 5A and 5B) disposed on a surface of the printed circuit board facing the fan. According to an embodiment, the printed circuit board may include a shield can (e.g., the shield can 253 of FIG. 5B) surrounding the electronic component. According to an embodiment, the printed circuit board may include a thermal conduction material (e.g., the thermal conduction material 254 of FIG. 5B) filling a gap between the shield can and the electronic component.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "coupled to," "connected with," or "connected towith" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which where data is semi-permanently stored in the storage medium and where a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device (101; 200) comprising:
a housing (210);
a first bracket (220), forming a through hole (221), disposed in the housing (210);
a first display (241), disposed on a surface (220a) of the first bracket (220), configured to be movable with respect to the first bracket (220);
a printed circuit board (PCB) (250) disposed on another surface (220b) of the first bracket (220) opposite to the surface (220a) of the first bracket (220);
a fan (270) disposed between the PCB (250) and the first bracket (220); and
a heat dissipation member (290) including:
a first region (290a) attached to a surface of the first display (241) facing the surface (220a) of the first bracket (220), and
a second region (290b), attached to the other surface(220b) of the first bracket (220), facing the fan (270),
wherein a portion (290c) of the heat dissipation member (290), between the first region (290a) and the second region (290b), passes through the through hole (221) and is configured to be deformable according to movement of the first display (241) with respect to the first bracket (220).

2. The electronic device (101; 200) of claim 1,
wherein the portion (290c) of the heat dissipation member (290) includes a plurality of extending portions (290d) connected to each other, and
wherein an angle between the plurality of extending portions (290d) is changed by the movement of the first display (241) with respect to the first bracket (220).

3. The electronic device (101; 200) of any one of claim 1 and 2,
wherein an area of the first region (290a) corresponds to an area of the surface of the first display (241).

4. The electronic device (101; 200) of any one of claim 1 to 3, further comprising a heat sink (280), disposed between the PCB (250) and the first bracket (220), including a plurality of pins (281) configured to pass airflow generated by the fan (270).
wherein the housing (210) includes at least one outlet (216), at least partially overlapping the heat sink (280) when the housing (210) is viewed from above, transmitting the airflow passing through the heat sink (280) to an outside of the housing (210).

5. The electronic device (101; 200) of any one of claim 1 to 4,
wherein the housing (210) further includes:
a first surface (210a) facing a user, when the electronic device (101; 200) is worn, and
at least one first inlet (214) penetrating the first surface (210a).

6. The electronic device (101; 200) of any one of claim 1 to 5,
wherein the housing (210) further includes:
a first surface (210a) facing a user, when the electronic device (101; 200) is worn,
a second surface (210b), opposite to the first surface(210a), spaced apart from the first surface(210a),
a lateral surface (210c) connecting the first surface (210a) and the second surface (210b), and
at least one second inlet (215) penetrating the lateral surface (210c).

7. The electronic device (101; 200) of any one of claim 1 to 6, further comprising:
a moving flange (230) including a portion coupled to the first display (241) in the housing (210), and another portion disposed outside the housing (210); and
a pinion gear (222) rotatable with respect to the first bracket (220),
wherein the moving flange (230) includes a rack gear (234), disposed in the portion of the moving flange (230), engaged with the pinion gear (222).

8. The electronic device (101; 200) of claim 7,
wherein the first region (290a) is configured to transfer heat emitted from the surface of the display to the portion of the moving flange (230) surrounding the first display (241).

9. The electronic device (101; 200) of claim 7,
wherein the moving flange (230) further includes a lens (233), coupled to the other portion of the moving flange (230), facing a body of a user when the electronic device (101; 200) is worn.

10. The electronic device (101; 200) of claim 7,
wherein the housing (210) forms at least one driving hole (211a, 211b) penetrating the housing (210), and
wherein the other portion of the moving flange (230) is disposed outside the housing (210) according to penetrating the at least one driving hole (211a, 211b).

11. The electronic device (101; 200) of any one of claim 1 to 10,
wherein the PCB (250) includes:
an electronic component disposed on a surface of the PCB (250) facing the fan (270),
a shield can (253) surrounding the electronic component, and
a thermal conduction material (254) filling a gap between the shield can (253) and the electronic component.

12. The electronic device (101; 200) of claim 10,
wherein the PCB (250) further includes an emission member (255) disposed on an outer surface of the shield can (253).

13. The electronic device (101; 200) of any one of claim 1 to 12,
wherein the PCB (250) includes a processor disposed on a surface of the PCB (250) facing the fan (270).

14. The electronic device (101; 200) of any one of claim 1 to 13, comprising:
a second bracket (260), accommodating the fan (270), disposed between the PCB (250) and the first bracket (220);
a first battery(261) coupled to the second bracket (260); and
a second battery (262), spaced apart from the first battery, coupled to the second bracket (260),
wherein the fan (270) is disposed between the first battery and the second battery.

15. The electronic device (101; 200) of any one of claim 1 to 14, further comprising a second display(242), spaced apart from the first display (241), configured to be movable, on the surface (220a) of the first bracket (220), in a direction approaching the first display (241) or in a direction away from the first display (241).

## Patentansprüche

1. Elektronische Vorrichtung (101; 200), umfassend:
ein Gehäuse (210);
eine erste Halterung (220), die ein Durchgangsloch (221) bildet und in dem Gehäuse (210) angeordnet ist;
eine erste Anzeige (241), die auf einer Oberfläche (220a) der ersten Halterung (220) angeordnet und so konfiguriert ist, dass sie in Bezug auf die erste Halterung (220) beweglich ist;
eine Leiterplatte (PCB) (250), die auf einer weiteren Oberfläche (220b) der ersten Halterung (220) gegenüber der Oberfläche (220a) der ersten Halterung (220) angeordnet ist;
einen Lüfter (270), der zwischen der PCB (250) und der ersten Halterung (220) angeordnet ist; und
ein Wärmeableitungselement (290), das Folgendes umfasst:
einen ersten Bereich (290a), der an einer der Oberfläche (220a) der ersten Halterung (220) zugewandten Oberfläche der ersten Anzeige (241) angebracht ist, und
einen zweiten Bereich (290b), der an der anderen Oberfläche (220b) der ersten Halterung (220) angebracht ist und dem Lüfter (270) zugewandt ist,
wobei ein Abschnitt (290c) des Wärmeableitungselements (290) zwischen dem ersten Bereich (290a) und dem zweiten Bereich (290b) durch das Durchgangsloch (221) verläuft und so konfiguriert ist, dass er entsprechend einer Bewegung der ersten Anzeige (241) in Bezug auf die erste Halterung (220) verformbar ist.

2. Elektronische Vorrichtung (101; 200) nach Anspruch 1,
wobei der Abschnitt (290c) des Wärmeableitungselements (290) mehrere miteinander verbundene Erstreckungsabschnitte (290d) umfasst, und
wobei ein Winkel zwischen den mehreren Erstreckungsabschnitten (290d) durch die Bewegung der ersten Anzeige (241) in Bezug auf die erste Halterung (220) geändert wird.

3. Elektronische Vorrichtung (101; 200) nach einem der Ansprüche 1 und 2,
wobei eine Fläche des ersten Bereichs (290a) einer Fläche der Oberfläche der ersten Anzeige (241) entspricht.

4. Elektronische Vorrichtung (101; 200) nach einem der Ansprüche 1 bis 3, umfassend ferner einen Kühlkörper (280), der zwischen der PCB (250) und der ersten Halterung (220) angeordnet ist und mehrere Stifte (281) umfasst, die so konfiguriert sind, dass sie einen vom Lüfter (270) erzeugten Luftstrom durchlassen,
wobei das Gehäuse (210) mindestens einen Auslass (216) umfasst, der, bei Betrachtung des Gehäuses (210) von oben, den Kühlkörper (280) zumindest teilweise überlappt und den durch den Kühlkörper (280) verlaufenden Luftstrom zu einer Außenseite des Gehäuses (210) überträgt.

5. Elektronische Vorrichtung (101; 200) nach einem der Ansprüche 1 bis 4,
wobei das Gehäuse (210) ferner Folgendes umfasst:
eine erste Oberfläche (210a), die einem Benutzer zugewandt ist, wenn die elektronische Vorrichtung (101; 200) getragen wird, und
mindestens einen ersten Einlass (214), der die erste Oberfläche (210a) durchdringt.

6. Elektronische Vorrichtung (101; 200) nach einem der Ansprüche 1 bis 5,
wobei das Gehäuse (210) ferner Folgendes umfasst:
eine erste Oberfläche (210a), die einem Benutzer zugewandt ist, wenn die elektronische Vorrichtung (101; 200) getragen wird,
eine zweite Oberfläche (210b), die der ersten Oberfläche (210a) gegenüberliegt und von der ersten Oberfläche (210a) beabstandet ist,
eine Seitenfläche (210c), die die erste Oberfläche (210a) und die zweite Oberfläche (210b) verbindet, und
mindestens einen zweiten Einlass (215), der die Seitenfläche (210c) durchdringt.

7. Elektronische Vorrichtung (101; 200) nach einem der Ansprüche 1 bis 6, umfassend ferner:
einen beweglichen Flansch (230) mit einem Abschnitt, der mit der ersten Anzeige (241) im Gehäuse (210) gekoppelt ist, und einem weiteren Abschnitt, der außerhalb des Gehäuses (210) angeordnet ist; und
ein Ritzel (222), das in Bezug auf die erste Halterung (220) drehbar ist,
wobei der bewegliche Flansch (230) eine Zahnstange (234) umfasst, die in dem Abschnitt des beweglichen Flansches (230) angeordnet ist und mit dem Ritzel (222) in Eingriff steht.

8. Elektronische Vorrichtung (101; 200) nach Anspruch 7,
wobei der erste Bereich (290a) dazu konfiguriert ist, von der Oberfläche der Anzeige abgegebene Wärme an den die erste Anzeige (241) umgebenden Abschnitt des beweglichen Flansches (230) zu übertragen.

9. Elektronische Vorrichtung (101; 200) nach Anspruch 7,
wobei der bewegliche Flansch (230) ferner eine Linse (233) umfasst, die mit dem anderen Abschnitt des beweglichen Flansches (230) gekoppelt und dem Körper eines Benutzers zugewandt ist, wenn die elektronische Vorrichtung (101; 200) getragen wird.

10. Elektronische Vorrichtung (101; 200) nach Anspruch 7,
wobei das Gehäuse (210) mindestens ein das Gehäuse (210) durchdringendes Antriebsloch (211a, 211b) bildet, und
wobei der andere Abschnitt des beweglichen Flansches (230) außerhalb des Gehäuses (210) angeordnet ist, entsprechend dem Durchdringen des mindestens einen Antriebslochs (211a, 211b).

11. Elektronische Vorrichtung (101; 200) nach einem der Ansprüche 1 bis 10,
wobei die PCB (250) Folgendes umfasst:
eine elektronische Komponente, die auf einer dem Lüfter (270) zugewandten Oberfläche der PCB (250) angeordnet ist,
eine die elektronische Komponente umgebende Abschirmdose (253) und
ein Wärmeleitmaterial (254), das einen Spalt zwischen der Abschirmdose (253) und der elektronischen Komponente ausfüllt.

12. Elektronische Vorrichtung (101; 200) nach Anspruch 10,
wobei die PCB (250) ferner ein Emissionselement (255) umfasst, das auf einer Außenfläche der Abschirmdose (253) angeordnet ist.

13. Elektronische Vorrichtung (101; 200) nach einem der Ansprüche 1 bis 12,
wobei die PCB (250) einen Prozessor umfasst, der auf einer dem Lüfter (270) zugewandten Oberfläche der PCB (250) angeordnet ist.

14. Elektronische Vorrichtung (101; 200) nach einem der Ansprüche 1 bis 13, umfassend:
eine zweite Halterung (260), die den Lüfter (270) aufnimmt und zwischen der PCB (250) und der ersten Halterung (220) angeordnet ist;
eine erste Batterie (261), die mit der zweiten Halterung (260) gekoppelt ist; und
eine zweite Batterie (262), die von der ersten Batterie beabstandet und mit der zweiten Halterung (260) gekoppelt ist,
wobei der Lüfter (270) zwischen der ersten Batterie und der zweiten Batterie angeordnet ist.

15. Elektronische Vorrichtung (101; 200) nach einem der Ansprüche 1 bis 14, umfassend ferner eine zweite Anzeige (242), die von der ersten Anzeige (241) beabstandet und so konfiguriert ist, dass sie auf der Oberfläche (220a) der ersten Halterung (220) in eine zur ersten Anzeige (241) hin weisende Richtung oder in eine von der ersten Anzeige (241) wegweisende Richtung bewegbar ist.

## Revendications

1. Dispositif électronique (101 ; 200) comprenant :
un boîtier (210) ;
un premier support (220), formant un trou traversant (221), disposé dans le boîtier (210) ;
un premier affichage (241), disposé sur une surface (220a) du premier support (220), configuré pour être mobile par rapport au premier support (220) ;
une carte de circuit imprimé (PCB) (250) disposée sur une autre surface (220b) du premier support (220) opposée à la surface (220a) du premier support (220) ;
un ventilateur (270) disposé entre la PCB (250) et le premier support (220) ; et
un élément de dissipation thermique (290) comprenant :
une première région (290a) fixée à une surface du premier affichage (241) faisant face à la surface (220a) du premier support (220), et
une seconde région (290b), fixée à l'autre surface (220b) du premier support (220), faisant face au ventilateur (270),
dans lequel une partie (290c) de l'élément de dissipation thermique (290), entre la première région (290a) et la seconde région (290b), passe à travers le trou traversant (221) et est configurée pour être déformable en fonction d'un mouvement du premier affichage (241) par rapport au premier support (220).

2. Dispositif électronique (101 ; 200) selon la revendication 1,
dans lequel la partie (290c) de l'élément de dissipation thermique (290) comprend une pluralité de parties d'extension (290d) reliées les unes aux autres, et
dans lequel un angle entre la pluralité de parties d'extension (290d) est modifié par le mouvement du premier affichage (241) par rapport au premier support (220).

3. Dispositif électronique (101 ; 200) selon l'une quelconque des revendications 1 et 2,
dans lequel une aire de la première région (290a) correspond à une aire de la surface du premier affichage (241).

4. Dispositif électronique (101 ; 200) selon l'une quelconque des revendications 1 à 3, comprenant en outre un dissipateur thermique (280), disposé entre la PCB (250) et le premier support (220), comprenant une pluralité d'ailettes (281) configurées pour laisser passer un flux d'air généré par le ventilateur (270),
dans lequel le boîtier (210) comprend au moins une sortie (216), chevauchant au moins partiellement le dissipateur thermique (280) lorsque le boîtier (210) est vu de dessus, transmettant le flux d'air passant à travers le dissipateur thermique (280) vers un extérieur du boîtier (210).

5. Dispositif électronique (101 ; 200) selon l'une quelconque des revendications 1 à 4,
dans lequel le boîtier (210) comprend en outre :
une première surface (210a) faisant face à un utilisateur, lorsque le dispositif électronique (101 ; 200) est porté, et
au moins une première entrée (214) traversant la première surface (210a).

6. Dispositif électronique (101 ; 200) selon l'une quelconque des revendications 1 à 5,
dans lequel le boîtier (210) comprend en outre :
une première surface (210a) faisant face à un utilisateur, lorsque le dispositif électronique (101 ; 200) est porté,
une seconde surface (210b), opposée à la première surface (210a), espacée de la première surface (210a),
une surface latérale (210c) reliant la première surface (210a) et la seconde surface (210b), et
au moins une seconde entrée (215) traversant la surface latérale (210c).

7. Dispositif électronique (101 ; 200) selon l'une quelconque des revendications 1 à 6, comprenant en outre :
une bride mobile (230) comprenant une partie couplée au premier affichage (241) dans le boîtier (210), et une autre partie disposée à l'extérieur du boîtier (210) ; et
un engrenage à pignon (222) rotatif par rapport au premier support (220),
dans lequel la bride mobile (230) comprend un engrenage à crémaillère (234), disposé dans la partie de la bride mobile (230), en prise avec l'engrenage à pignon (222).

8. Dispositif électronique (101 ; 200) selon la revendication 7,
dans lequel la première région (290a) est configurée pour transférer de la chaleur émise depuis la surface de l'affichage vers la partie de la bride mobile (230) entourant le premier affichage (241).

9. Dispositif électronique (101 ; 200) selon la revendication 7,
dans lequel la bride mobile (230) comprend en outre une lentille (233), couplée à l'autre partie de la bride mobile (230), faisant face à un corps d'un utilisateur lorsque le dispositif électronique (101 ; 200) est porté.

10. Dispositif électronique (101 ; 200) selon la revendication 7,
dans lequel le boîtier (210) forme au moins un trou d'entraînement (211a, 211b) traversant le boîtier (210), et
dans lequel l'autre partie de la bride mobile (230) est disposée à l'extérieur du boîtier (210) en traversant l'au moins un trou d'entraînement (211a, 211b).

11. Dispositif électronique (101 ; 200) selon l'une quelconque des revendications 1 à 10,
dans lequel la PCB (250) comprend :
un composant électronique disposé sur une surface de la PCB (250) faisant face au ventilateur (270),
un boîtier de blindage (253) entourant le composant électronique, et
un matériau de conduction thermique (254) remplissant un espace entre le boîtier de blindage (253) et le composant électronique.

12. Dispositif électronique (101 ; 200) selon la revendication 10,
dans lequel la PCB (250) comprend en outre un élément d'émission (255) disposé sur une surface extérieure du boîtier de blindage (253).

13. Dispositif électronique (101 ; 200) selon l'une quelconque des revendications 1 à 12,
dans lequel la PCB (250) comprend un processeur disposé sur une surface de la PCB (250) faisant face au ventilateur (270).

14. Dispositif électronique (101 ; 200) selon l'une quelconque des revendications 1 à 13, comprenant :
un second support (260), logeant le ventilateur (270), disposé entre la PCB (250) et le premier support (220) ;
une première batterie (261) couplée au second support (260) ; et
une seconde batterie (262), espacée de la première batterie, couplée au second support (260),
dans lequel le ventilateur (270) est disposé entre la première batterie et la seconde batterie.

15. Dispositif électronique (101 ; 200) selon l'une quelconque des revendications 1 à 14, comprenant en outre un second affichage (242), espacé du premier affichage (241), configuré pour être mobile, sur la surface (220a) du premier support (220), dans une direction se rapprochant du premier affichage (241) ou dans une direction s'éloignant du premier affichage (241).
